# EUROPEAN PATENT APPLICATION

(11) **EP 0 603 970 A1**
(43) Date of publication of application: **29.06.1994**
(21) Application number: 93203606.4
(22) Date of filing: 21.12.1993
(51) Int. Cl.: H04S 7/00, H04S 5/02, H03G 5/04

(54) **Sound reproduction system as well as adjusting circuit to be used in such a system**

(30) Priority: 23.12.1992 EP 92204067
(71) Applicant: Philips Electronics N.V., 5621 BA Eindhoven (NL)
(72) Inventor: Schlösser, Theodoor Antoon Jozef, NL-5656 AA Eindhoven (NL); Sessink, Franciscus Josephus Alfonsus Maria, NL-5656 AA Eindhoven (NL); Huiberts, Mauritius Laonardus Maria, NL-5656 AA Eindhoven (NL)
(74) Representative: Groenendaal, Antonius Wilhelmus Maria

(57) **Abstract**

A sound reproduction system has inputs (20, 21) for receiving audio signals (L, R). The received audio signals are split up into low-frequency audio signals (L1, R1) and high-frequency signals (Lh, Rh) by low-pass filters (23, 23a). Adjusting circuits (24, 24a) split up the high-frequency audio signals (Lh, Rh) into first sub-signals (Lh1, Rh1) and second sub-signals (Lh2, Rh2) which have, in essence, the same frequency spectra. The signal strength ratios between the first and second sub-signals can be adjusted by the adjusting circuits (24, 24a). Signal combining means (25, 25a) combine the low-frequency audio signals (L1, R1) with the second sub-signals (Lh2, Rh2). The signals obtained from the combination are fed as loudspeaker signals (LA, RA) to loudspeakers installed at the rear, left and at the rear, right in a passenger's compartment of a motor car. The sub-signals (Lh1, Rh1) are fed to loudspeakers installed at the front, left and at the front, right in the passenger's compartment.

The advantage of the sound reproduction system is that in the case where the loudspeakers installed at the rear are better capable of reproducing the bass tones than the loudspeakers installed at the front, the tone colour of the reproduced sound is not affected by a change of the adjustment of the signal strength ratio.

## Description

The invention relates to a sound reproduction system for reproducing sound in a space, the system comprising at least a loudspeaker a first type and at least a second loudspeaker of a second type, the loudspeakers of the first and second types being installed, in essence, on different sides of a listener's position in the space, the loudspeaker of the second type being more suitable for reproducing low-frequency sound than the loudspeaker of the first type, a supply circuit for supplying a first and a second loudspeaker signal to the respective loudspeakers of the first and second types, the supply circuit comprising an adjusting circuit for adjusting the ratio between the signal strengths of the first and second loudspeaker signals.

The invention further relates to an adjusting circuit to be used in such a system.

A sound reproduction system of the type defined above is known, for example, from EP-A 0 166 543. The system described there is to be used in a passenger's compartment of a private car. Both the left audio channel signal and the right audio channel signal of a stereo audio signal are split up into two loudspeaker signals. One of the loudspeaker signals obtained from the left audio channel signal is fed to a loudspeaker installed at the front, left in the passenger's compartment, whereas the other loudspeaker signal is fed to a loudspeaker installed at the rear, left in the passenger's compartment. In identical manner the loudspeaker signals obtained from the right audio channel signal are fed to loudspeakers installed at the front, right and at the rear, right in the passenger's compartment. The loudspeakers installed at the front are often installed in the facia. Since the space for accommodating loudspeakers in the facia is small, the loudspeakers installed in the facia are generally smaller than the loudspeakers installed at the rear, for which usually considerably more space is available. If the ratio between the signal strength of the loudspeaker signals for a loudspeaker installed at the front and the signal strength of the loudspeaker signals for a loudspeaker installed at the rear is changed, the tone colour of the sound will unintentionally change considerably. This is caused by the fact that the small loudspeakers in the facia are less suitable for reproducing bass tones than the larger loudspeakers installed at the rear. A change in the ratio between the signal strength of the loudspeaker signals of the loudspeakers installed at the front and the signal strength of the loudspeaker signals for the loudspeakers installed at the rear then results in a considerable change of the volume of the bass tone reproduction.

It is an object of the invention to provide a sound reproduction system in which a change in the ratio between the strengths of the loudspeaker signals for the loudspeakers installed at the front and the loudspeakers installed at the rear affects the tone colour of the reproduced sound to a smaller extent.

According to the invention this object is achieved by a sound reproduction system as defined in the opening paragraph, characterized in that the adjusting circuit is arranged for essentially exclusively adjusting the ratio between the signal strengths of signal components whose frequencies lie above a specific cross-over frequency.

Since the adjustment of the ratio between the signal strengths does not affect the low-frequency contents of the loudspeaker signals, the power of the bass tone is not modified by this adjustment. A considerably changed tone colour is then avoided too.

An embodiment of the sound reproduction system which is attractive because it is simple to realise is characterized in that the supply circuit has an input for receiving an audio signal, low-pass filter means for deriving from the audio signal a low-frequency audio signal having essentially exclusively signal components below said cross-over frequency, and deriving means for deriving from the audio signal a first and a second sub-signal having essentially exclusively signal components above said crossover frequency, the adjusting circuit being arranged for adjusting the ratio between the signal strengths of the first and second sub-signals, the sound reproduction system further including signal combining means for combining the low-frequency audio signal with the second and/or first sub-signal, while signals obtained from the combination form the second and/or first loudspeaker signal.

The invention is pre-eminently suitable for use in a passenger's compartment of a vehicle. However, it is not restricted thereto. It may likewise be used in spaces in which loudspeakers are installed on different sides of a listener's position and of which loudspeakers the suitability for reproducing low-frequency sound shows mutual differences.

A further embodiment of the sound reproduction system is characterized in that the sound reproduction system comprises at least a loudspeaker of a third type which is better suitable for reproducing low-frequency sound than the loudspeaker of the first type, the system comprising means for feeding to the third-type loudspeaker a third loudspeaker signal which includes at least the low-frequency audio signal.

In this embodiment the same low-frequency audio signal is fed to the loudspeakers installed at different positions. Since the position at which the low-frequency sound signals are generated is hard to perceive or cannot be perceived at all in small spaces like the passenger's compartment of a vehicle, there is no objection to supplying the same low-frequency audio signal to loudspeakers at different positions. Using all the loudspeakers that are suitable for reproducing low-frequency sound for low frequencies is additionally advantageous in that the total low-frequency power of the reproduced sound may be large without a special woofer being used.

In this respect it should be observed that the loudspeakers of the second type and the loudspeakers of the third type may be identical.

Since the position of the loudspeakers does not affect the reproduction of low-frequency sound in a small space, it is advantageous to make the low-frequency contents of the loudspeaker signals for all the loudspeakers of a stereo sound reproduction system independent of the left/write balance and the front/rear balance.

The invention will be further explained hereinafter with reference to the drawing Figures 1 to 10, in which
Fig. 1 shows a sound reproduction system to be used in a private car,
Figs. 2, 3, 6, 7 and 10 show block diagrams of sound reproduction systems according to the invention,
Figs. 4 and 5 show transfer characteristics, and
Fig. 9 shows by way of illustration an optional loudspeaker lay-out in a passenger's compartment of a vehicle.

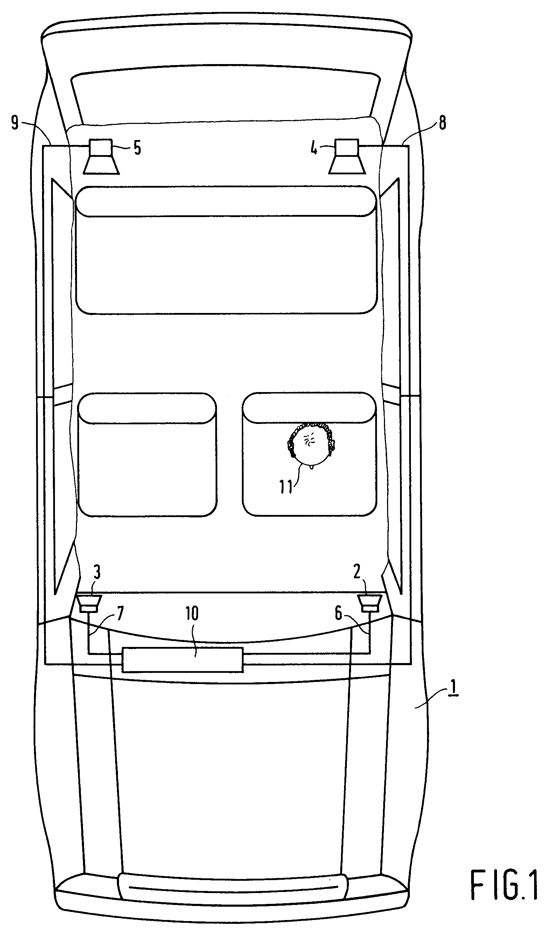

Fig. 1 shows in a diagram a passenger's compartment of a private ear 1. Reference character 11 denotes a passenger's listening position. A loudspeaker 2 is installed to the left, front of the listening position 11. A loudspeaker 3 is installed to the right, front of the listening position 11. A loudspeaker 4 is installed to the left, rear of the listening position 11 and a loudspeaker 5 is installed to the right, rear of the listening position 11. The available space for the loudspeakers 2 and 3 is smaller than the space available at the rear for the loudspeakers 4 and 5. Therefore, smaller types of loudspeakers are selected for the loudspeakers 2 and 3 than those for the loudspeakers 4 and 5 in the rear. Due to their smaller dimensions, the loudspeakers 2 and 3 are less capable of reproducing bass tones than the loudspeakers 4 and 5 installed in the rear. The loudspeakers 2, 3, 4 and 5 are fed with the respective loudspeaker signals LV, RV, LA and RA supplied by a supply circuit 10 through the respective signal lines 6, 7, 8, 9.

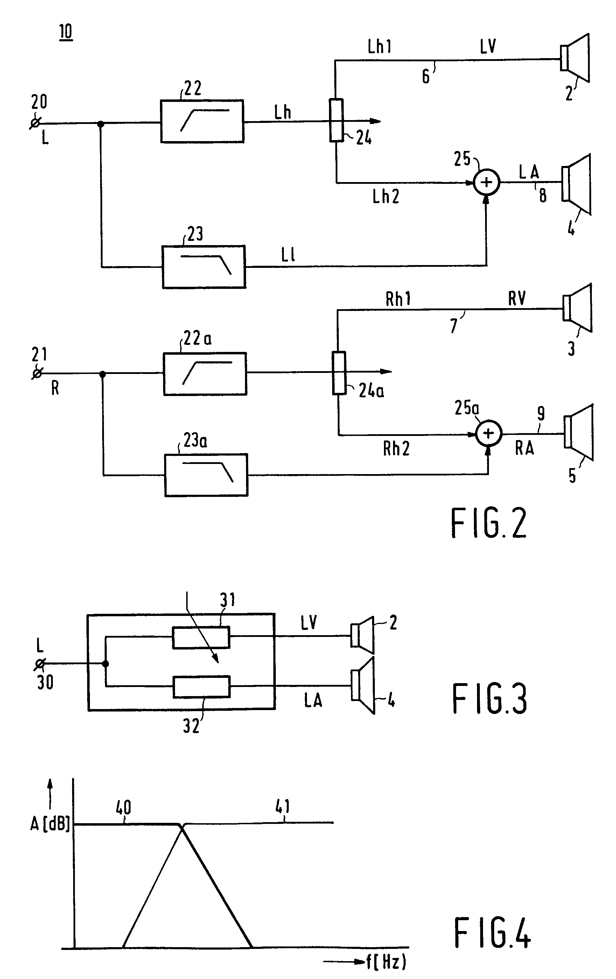

Fig. 2 shows an embodiment for the supply circuit 10 according to the invention. The supply circuit 10 has an input 20 and an input 21 for receiving a left audio channel signal L and a right audio channel signal R of a stereo audio signal. The left audio channel signal is split up into a low-frequency audio signal L1 and a high-frequency audio signal Lh by a high-pass filter 22 and a low-pass filter 23. In this respect a high-frequency audio signal is meant to be understood as an audio signal comprising the higher frequency components of an audio signal. A low-frequency audio signal is meant to be understood here as a signal essentially comprising the lower frequencies of an audio signal. The cross-over frequency of the filters 22 and 23 is preferably the same. Suitable values for the cross-over frequency lie below 300 Hz, for example, 200 Hz. For that matter, in the passenger's compartment of a private car the position of the sound source that generates tones below 300 Hz cannot be perceived or can hardly be perceived by a listener.

The response curves of the filters 22 and 23 are shown in Fig. 4 for illustration. The curve 40 shows the response curve of the low-pass filter 22. The curve 41 shows the response curve of the high-pass filter 23.

The high-frequency audio signal Lh is fed to an adjusting circuit 24 of a customary type, which splits up this signal into two sub-signals Lh1 and Lh2 that have identical frequency spectra, but have a signal strength ratio that can be adjusted. Although it is not required, it is customary that with such an adjusting the sum of the signal strengths of the sub-signals Lh1 and Lh2 remains the same if the ratio adjustment is changed.

The sub-signal Lh1 is fed as the loudspeaker signal LV to the loudspeaker 2 in a customary fashion through a final amplifier (not shown). The sub-signal Lh2 is combined with the low-frequency audio signal L1 by a signal combining circuit 25, for example, formed by an adder circuit. A signal obtained through the combination may be tapped from an output of the combining circuit. This signal on the output of the combining circuit forms the loudspeaker signal LA which is fed to the loudspeaker 4 in a customary fashion through a final amplifier (not shown).

Similar to the left signal the loudspeaker signals RV and RA for the loudspeakers 3 and 5 are derived from the right audio channel signal. The required filters 22a and 23a and circuits 24a and 25a are similar to the filters 22 and 23 and circuits 24 and 25.

In the embodiment shown in Fig. 2 the low-frequency audio signal L1 is only combined with the sub-signal Lh2. Alternatively, however, it is possible to combine the low-frequency signal with both sub-signals Lh1 and Lh2. It is only essential that the ratio between the signal strengths of the low-frequency components in the loudspeaker signals LV and LA be not affected by the ratio between the signal strengths of the sub-signals Lh1 and Lh2. In that case the tone colour of the sound image will not change if the ratio is changed. For, since the low-frequency contents of the loudspeaker signals are not changed, the fact that the loudspeakers have each a different suitability to reproducing bass tones does not affect the tone colour.

In the embodiment described hereinbefore the low-frequency audio signal for each of the audio channel signals is derived separately from the received audio channel signals L and R through filtering. Figs. 6, 7 and 8 show the embodiments in which the low-frequency audio signals are derived in different fashions. In the Figs. 6, 7 and 8 the elements corresponding to the elements of the embodiment shown in Fig. 2 are denoted by like reference characters.

Furthermore, the low-frequency components are removed from the sub-signals Lh1, Lh2, Rh1, Rh2 by high-pass filters 22b connected to the outputs of the adjusting circuits 24 and 24a *in lieu* of high-pas filters inserted upstream of the adjusting circuits as shown in the embodiment of Fig. 2.

In the embodiment of Fig. 6 the high-frequency sub-signals Lh2 and Rh2 are combined with a low-frequency signal Ls which is the same for either combination. The signal Ls is obtained by adding together the left audio channel signal L and the right audio channel signal R in an adder circuit 60 and filtering the added signal by a low-pass filter 61.

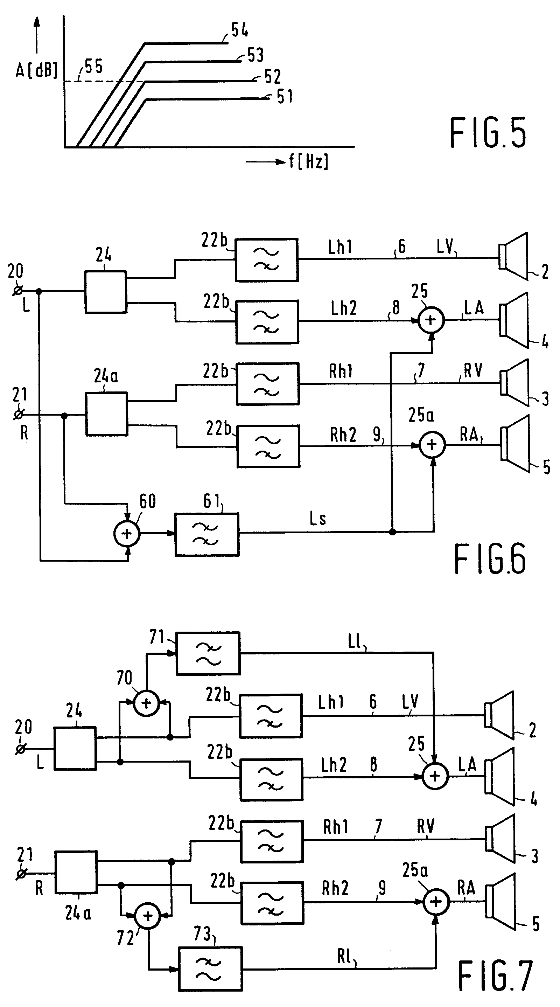

In the embodiment shown in Fig. 7 the sub-signals Lh2 and Rh2 are combined with different low-frequency signals L1 and R1. The signal L1 combined with the high-frequency sub-signal Lh2 is obtained by adding together the two output signals of the adjusting circuit 24 by an adder circuit 70 and then subtracting the high-frequency components from the added signal by a low-pass filter 71. The low-frequency signal R1 which is combined with the high-frequency sub-signal Rh2 is obtained in similar fashion by an adder circuit 72 and a low-pass filter 73.

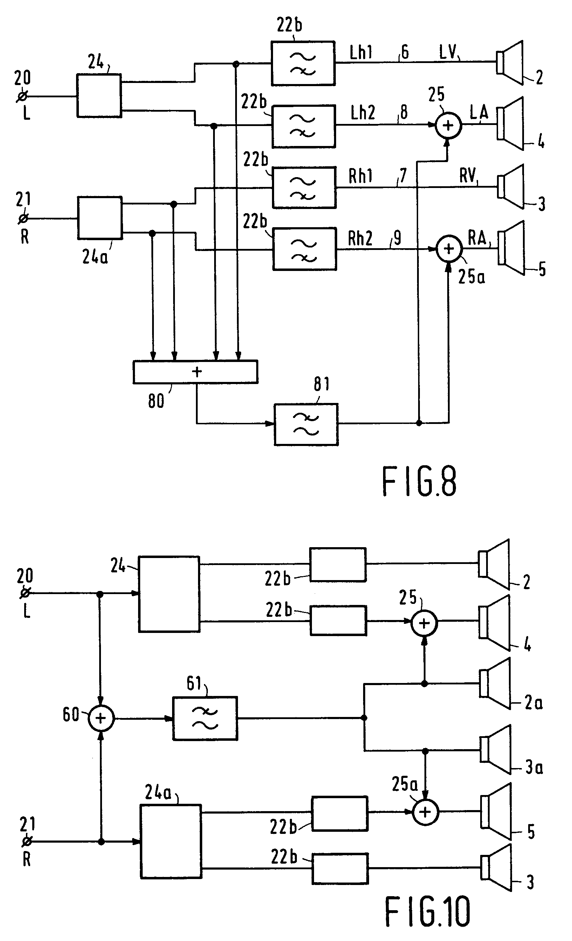

In the embodiment shown in Fig. 8 the high-frequency sub-signals Lh2 and Rh2 are again combined with the low-frequency sum signal Ls. In this embodiment the sum signal Ls is obtained by adding together all four input signals available on the outputs of the adjusting circuits 24 and 24a by an adder circuit 80. The low-frequency sum signal Ls is obtained by filtering the added signal by a low-pass filter 81.

In the embodiments shown in Figs. 6 and 8, the same low-frequency audio signal is fed to loudspeakers installed at different positions. Since the position where the low-frequency sound signals are generated cannot be perceived or is hardly perceivable in small spaces such as the passenger's compartment of a vehicle, there is no objection to supplying the same low-frequency audio signal to loudspeakers at different positions. Moreover, supplying the same low-frequency signal is advantageous in that the signal can be processed with fewer circuit components. In view of the fact that the position of the sound source is unimportant for reproducing low-frequency sound, it is advantageous to reproduce low-frequency sound with all the loudspeakers suitable for this purpose and present in the space. This is advantageous in that the total low-frequency power of the reproduced sound may be large without special woofers being used.

Since the position of the loudspeakers does not affect the reproduction of low-frequency sound in a small space, it is advantageous to render the low-frequency contents of the loudspeaker signals for all the loudspeakers in a stereo sound reproduction system independent of the left/right balance and the front/rear balance.

In many cases loudspeakers in vehicles are not only installed in the facia, but also in the door panels of the vehicle. The space available in the door panels is generally larger than the space available in the facia. Therefore, it is possible to install larger loudspeakers in the door panels. It is then to be preferred to feed the low-frequency audio signal also to these loudspeakers installed in the door panels.

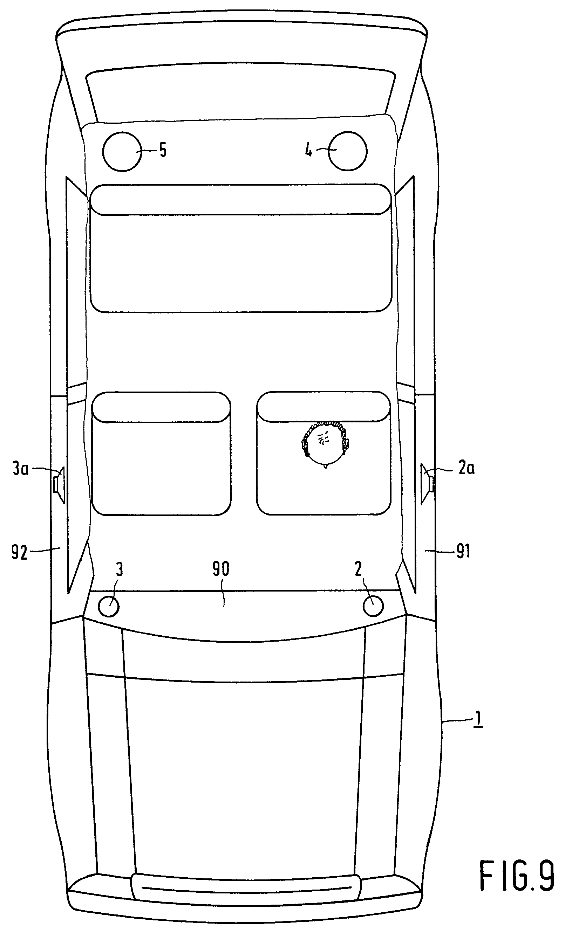

Fig. 9 shows by way of illustration in a diagram the passenger's compartment of a vehicle in which the loudspeakers 2 and 3 are installed in a facia 90. In a door panel 91 on the left in the vehicle a loudspeaker 2a is installed, whereas a loudspeaker 3a is installed in a door panel 92 on the right in the vehicle.

The loudspeakers 4 and 5 are installed at the rear in the passenger's compartment, for example, attached to a backshelf.

Fig. 10 shows an adapted embodiment of the embodiment shown in Fig. 6. In the adapted embodiment the low-frequency audio sum signal Ls is fed to the loudspeakers 2a and 3a in addition to being fed to the combining circuits 25 and 25a. Generally, more space is available for installing the loudspeakers 2 and 3 than for installing the loudspeakers 2a and 3a. The dimensions of these loudspeakers may thus be larger than those of the loudspeakers 2 and 3. Therefore, the loudspeakers 2a and 3a may also be selected to be loudspeakers of a type better suitable for bass tone reproduction than the loudspeakers 2 and 3. The loudspeakers 2a and 3a may be of the same type as the loudspeakers 4 and 5. Alternatively, however, it is possible to select loudspeakers of a different type from the loudspeakers 4 and 5.

Fig. 3 shows a different embodiment of the supply circuit 10 according to the invention. The supply circuit has an input for receiving the left audio channel signal L. The signal L received on the input 30 is applied to an adjusting circuit 31. The adjusting circuit 31 is a circuit of a type in which the signal strength of the signal components above a specific cross-over frequency can be adapted, whereas the signal strength of the signal components below this cross-over frequency cannot be adapted by the adjusting circuit. The transfer characteristic of the adjusting circuit 31 for different adjustments is referenced 51, 52, 53 and 54 in Fig. 5. The signal thus processed by the adjusting circuit 31 can be fed to the loudspeaker 2 as the loudspeaker signal Lv.

The loudspeaker signal LA for loudspeaker 4 is derived from the signal L received through input 30 by means of a circuit 32 which has a fixed frequency characteristic. By way of illustration the transfer characteristic of the circuit 32 is denoted by a dashed line 55.

Fig. 3 merely shows the processing of the left audio channel signal L. The processing of the right audio channel signal may be effected in similar fashion.

The invention has been described for use in a vehicle. However, it should be observed that the use of the invention is not restricted to vehicles. In principle, the invention may be used in any space whose dimensions are such that for bass tones the position of the sound source cannot be perceived or can hardly be perceived by the listener.

## Claims

1. Sound reproduction system for reproducing sound in a space, the system comprising at least a loudspeaker of a first type and at least a second loudspeaker of a second type, the loudspeakers of the first and second types being installed, in essence, on different sides of a listener's position in the space, the loudspeaker of the second type being more suitable for reproducing low-frequency sound than the loudspeaker of the first type, a supply circuit for supplying a first and a second loudspeaker signal to the respective loudspeakers of the first and second types, the supply circuit comprising an adjusting circuit for adjusting the ratio between the signal strengths of the first and second loudspeaker signals, characterized in that the adjusting circuit is arranged for essentially exclusively adjusting the ratio between the signal strengths of signal components whose frequencies lie above a specific cross-over frequency.

2. Sound reproduction system as claimed in Claim 1, characterized in that the loudspeaker of the first type is installed at the front in a passenger's compartment of a vehicle, whereas the loudspeaker of the second type is installed at the rear in the passenger's compartment.

3. Sound reproduction system as claimed in Claim 1 or 2, characterized in that the supply circuit has an input for receiving an audio signal, low-pass filter means for deriving from the audio signal a low-frequency audio signal having essentially exclusively signal components below said cross-over frequency, and deriving means for deriving from the audio signal a first and a second sub-signal having essentially exclusively signal components above said cross-over frequency, the adjusting circuit being arranged for adjusting the ratio between the signal strengths of the first and second sub-signals, the sound reproduction system further including signal combining means for combining the low-frequency audio signal with the second and/or first subsignal, while signals obtained from the combination form the second and/or first loudspeaker signal.

4. Sound reproduction system as claimed in Claim 3, characterized in that the sound reproduction system comprises at least a loudspeaker of a third type which is better suitable for reproducing low-frequency sound than the loudspeaker of the first type, the system comprising means for feeding to the third-type loudspeaker a third loudspeaker signal which includes at least the low-frequency audio signal.

5. Stereo sound reproduction system for reproducing stereophonic sound that comprises a left and a right sound signal, the stereo sound reproduction system for reproducing the left sound signal comprising a sound reproduction system as claimed in Claim 3 or 4, and the stereo sound reproduction system for reproducing the right sound signal comprising a second sound reproduction system as claimed in Claim 3 or 4.

6. Stereo sound reproduction system as claimed in Claim 5, characterized in that in the stereo sound reproduction system the low-pass filter means comprise deriving means for deriving a low-frequency sum signal which is formed by the sum of low-frequency components in the left and right audio channel signals, the sum signal being the low-frequency audio signal.

7. Supply circuit for supplying first and second loudspeaker signals to a first loudspeaker of the first type and a second loudspeaker of the second type respectively, the supply circuit comprising an adjusting circuit for adjusting the signal strength ratio between the signal strengths of the first and second loudspeaker signals, characterized in that the adjusting circuit is arranged for essentially exclusively adjusting the ratio between the signal strengths of signal components whose frequencies lie above a specific cross-over frequency.

8. Supply circuit as claimed in Claim 7, characterized in that the supply circuit has an input for receiving an audio signal, low-pass filter means for deriving from the audio signal a low-frequency audio signal essentially exclusively comprising signal components below said cross-over frequency, and means for deriving from the audio signal a first and a second sub-signal essentially exclusively comprising signal components above said cross-over frequency, the adjusting circuit being arranged for adjusting the signal strength ratio between the first and second sub-signals, and the sound reproduction system further including signal combining means for combining the low-frequency audio signal with the second and/or first sub-signal, the signals obtained through the combination forming the second and/or first loudspeaker signal.

9. Supply circuit as claimed in Claim 8, characterized by supply means for supplying a third loudspeaker signal comprising at least the low-frequency audio signal to a loudspeaker of a third type.

10. Supply circuit as claimed in Claim 7, characterized in that the supply circuit has a first input for receiving a left audio channel signal, a second input for receiving a right audio channel signal, low-pass filter means for deriving from the left and right audio channel signals a low-frequency audio sum signal that essentially exclusively comprises signal components below said cross-over frequency of the sum of the left and right audio channel signals, deriving means for deriving from the left audio channel signal a first and a second left sub-signal that essentially exclusively comprises signal components above said cross-over frequency, the adjusting circuit being arranged for adjusting the signal strength ratio between the first and second left sub-signals, and the supply circuit further including signal combining means for combining the low-frequency audio sum signal with the second and/or first left sub-signal, deriving means for deriving from the right audio channel signal a first and a second right sub-signal that essentially exclusively comprises signal components above said cross-over frequency, the adjusting circuit being arranged for adjusting the signal strength ratio between the first and the second right sub-signal, and the supply circuit further including signal combining means for combining the low-frequency audio sum signal with the second and/or first right sub-signal.
